# EUROPEAN PATENT SPECIFICATION

(11) **EP 0 508 059 B1**
(45) Date of publication and mention of the grant of the patent: **16.10.1996**
(21) Application number: 92102231.5
(22) Date of filing: 11.02.1992
(51) Int. Cl.: H01H 85/20, H05K 5/00, B60R 16/02

(54) **Fuse-carrier case having a modular structure**
Sicherungshaltergehäuse modularer Struktur
Boîte de porte-fusible ayant une structure modulaire

(30) Priority: 08.04.1991 IT MI910955
(43) Date of publication of application: 14.10.1992
(73) Proprietor: MECCANOTECNICA CODOGNESE S.p.A., I-20073 Codogno (MI) (IT)
(72) Inventor: Falchetti, Antonio, I-20073 Codogno, Milano (IT)
(74) Representative: Checcacci, Giorgio

(56) References cited:
- EP-A- 0 116 991
- EP-A- 0 170 455
- DE-A- 1 513 494
- DE-A- 2 821 992

## Description

This invention relates to a fuse-carrier case of a kind intended for installation on vehicles in order to accommodate fuses, relays, connectors, and the like electrical devices, in correspondingly arranged seats therein, and comprising a plurality of carrier cases each reserved for one type of said electrical devices and peripherally arranged interfit means and counter-means adapted to releasably hold together in a modular fashion said plurality of carrier cases (EP-A-0 116 991).

As is known, in the specific environment of this invention, the manufacturer of motor vehicles requires a supply of fuse carriers, relay carriers, and the like articles in order to properly accommodate therein a number of protection and/or control devices for operating electric apparatus with which the vehicles are equipped.

It may be appreciated that where a vehicle is to a design model intended for large scale production, as may be the case with modern automobiles, it pays to have such carriers specifically designed to meet the manufacturer's own demands, so as to have the various seats for the fuses, relays, and any connectors integrated and unitized therein. With such large-volume supplies assured, the unit cost of the carriers can be in fact minimized.

In some other situations, however, the so-called circulation, or planned inroad, of a vehicle model may deny the saving potential from mass-production of its accessories, such as the fuse carriers.

This may be the case, for example, with small-size industrial vehicles or sport cars manufactured on a limited series basis.

With these vehicle products, the alternatives are either to accept a high unit cost for the accessory, by having it specially manufactured in small quantities, or to use carriers already available for other vehicle types, but which most likely fall short of meeting individual specifications for space and convenience of installation.

Between the known art solutions, DE-A-2821992 illustrates a structure for accepting fuses which comprises a principal body provided with complementary blocks, mounted to said body by means of overhang plugs.

Such a structure can easily move in any direction, being not provided with locking-means.

Furthermore, a fuseholder unit, provided with integral means for engaging to a panel, is disclosed in EP-A-0 116 991. Such a unit allow the settle of a single fuse.

Even, EP-A-0 170 455 describes a modular device of an interface board for mounting electrical connectors which comprises a plurality of interlocked modular blocks on which the connectors are mounted.

Each side face of each block has locking elements which engage with complementary locking elements on another of said blocks to prevent relative lateral motion. The adjacent blocks are locked into position against motion in any direction using double-sided wedges coupled with dovetail mortises along the side faces of said blocks.

The current state of the art provides no viable alternatives, aside from the above-mentioned ones, and leaves the manufacturer of vehicles burdened with a self-evident drawback.

The underlying technical problem of this invention is to provide a fuse, relay, and the like carrier box which has such constructional and performance features as to reconcile the conflicting requirements of adaptability to a range of different vehicle models, thereby to meet the vehicle manufacturer's demands, and have a low unit production cost.

The solutive idea on which this invention stands is one of making a fuse-carrier case having a modular construction obtained by assembling together structurally independent portions thereof.

Based on this solutive idea, the technical problem is solved by a carrier box as indicated being characterized in that it comprises peripherally arranged interfit means and counter-means adapted to releasably hold together in a modular fashion a plurality of carrier cases each reserved for one type of said electrical devices.

The features and advantages of a fuse-carrier case according to the invention will become apparent from the following detailed description of an embodiment thereof, given by way of example and not of limitation with reference to the accompanying drawings.

In the drawings:
Figure 1 is an exploded perspective view of a fuse-carrier case according to the invention;
Figure 2 is an exploded perspective view of another embodiment of the carrier case shown in Figure 1;
Figure 3 is a perspective view of a pair of carrier cases on the point of being assembled modularly together; and

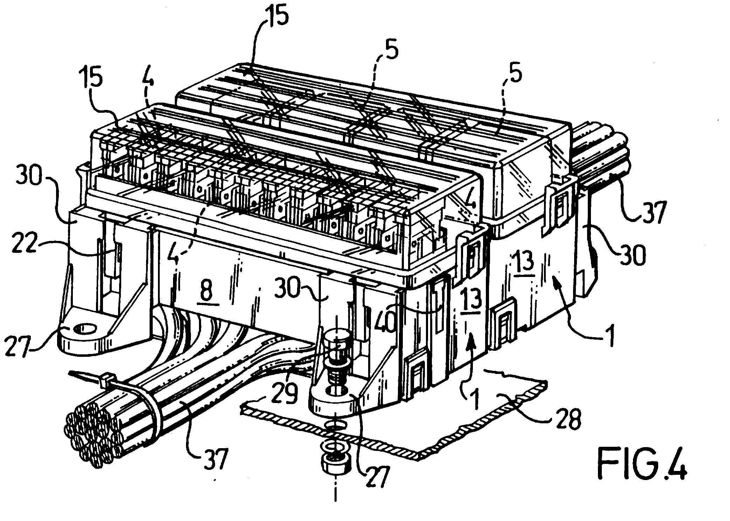

Figure 4 is a perspective view showing the carrier cases of Figure 3 in their in-use condition.

With reference to the drawing views, generally shown at 1 is a fuse, relay and the like carrier case embodying this invention.

The case 1 is basically parallelepipedal in shape with an open bottom, and has a top wall 2 and oppositely located side walls, of which the longitudinal ones are designated 13 and the remaining ones designated 14.

Defined in the top wall 2 are seats 3 for receiving fuses 4, relays 5, or some other electrical devices therein, either for protection or control purposes, not shown because conventional.

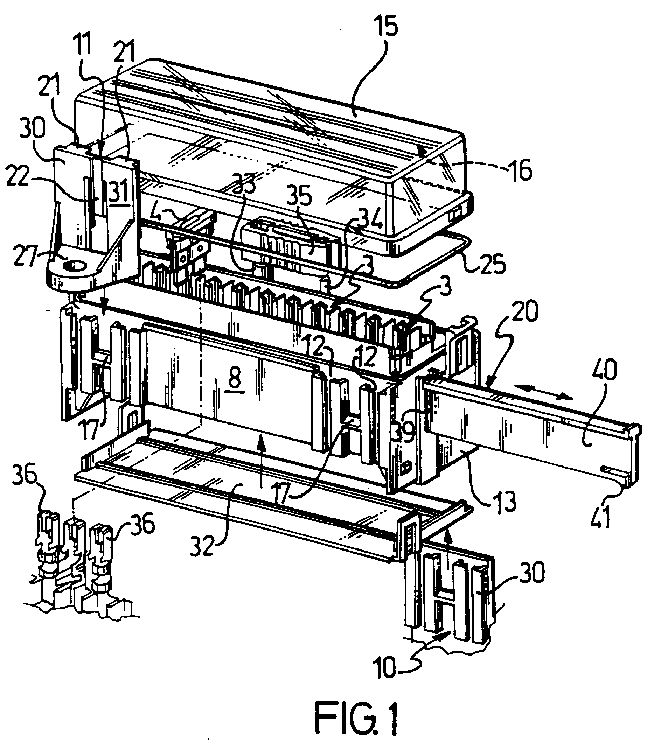

In the embodiment considered, and shown in Figure 1, the case has its top wall 2 formed with a set of adjacently aligned seats 3 for receiving fuses 4 of the so-called knife type. These seats are sided by two pegs 33 and 34 adapted to hold tongs 35 for pulling out the fuses.

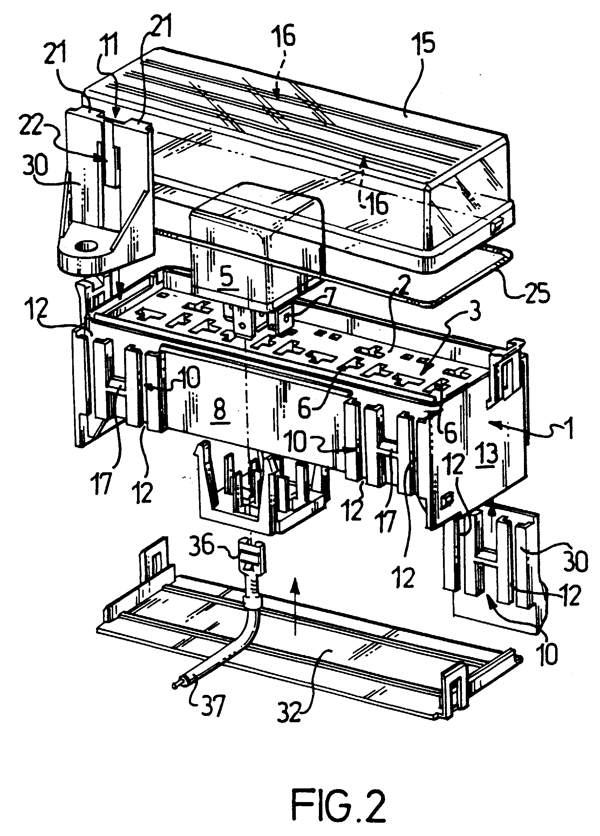

Figure 2 shows a carrier case quite similar to the previous one, but having its top wall 2 slightly recessed and formed with plural holes 6 constituting sockets for the flat pins 7 of relays 5.

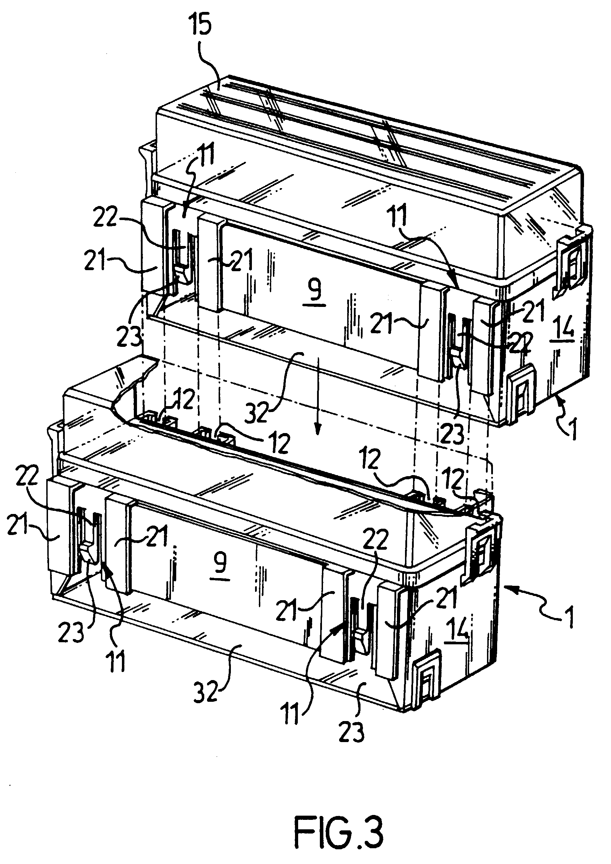

Advantagously, the carrier 1 includes peripherally arranged interfit means 10 and mating counter-means 11 for holding together plural carrier cases in a modular fashion, as shown in Figure 3.

These means 10 and counter-means 11 are formed integrally with the longitudinal side walls 8 and 9 of the case 1. The means 10 comprise essentially a pair of T-shaped guiding grooves 12 which lie parallel and vertically across each end of the longitudinal wall 8. A connection member 17 is provided between said grooves.

The counter-means 11 locate on the opposite ends of side wall 9 and comprise a pair of rails 21, lying parallel and having a T-shaped cross-section, which are adapted to slide into the grooves 12. Provided between said rails 21 is a tab 22, being cut out of the wall 9 and compliant and formed on its free end with a locking spear 23 essentially in the form of a ratchet pawl.

The means 10 and counter-means 11 from adjacent case can be interfitted by sliding the rails 21 into the corresponding grooves 12, and engaging the the spear end 23 of tab 22 by snap action with the member 17 lying between the grooves 12.

Snap fitted over each carrier box 1 in a removable manner is a clear cover 15, optionally provided with an intervening seal 25. This cover 15 has projections 16 which extend inwards at the locations of said electrical devices 4 or 5 and abut against the latter with the cover secured in its closed position.

More specifically, the projections 16 are obtained by grooving the interior of the cover 15 lengthwise.

Also provided is a bottom wall 32 which is, in turn, a snap fit over the case 1, on the remote side thereof from the cover 15. This wall leaves the case 1 open downwardly to enable leads 37 to be passed thereinto which are run to terminals 36 of the "fast-on" variety for providing electric connection to the devices 4 or 5.

It should be noted for completeness of illustration that the carrier case 1 may include additional locking means 20 to prevent the terminals 36 from being pulled out of their connected position.

For this purpose, said locking means 20 comprise a bar 40 which can be slid in a guided fashion through an opening 39 formed in a side wall 13 of the case, to interfere substantially latch-like with each of said terminals 36. The bar 40 has a locking pawl 41 adapted to snap into engagement on passing said opening 39.

The carrier case 1 is also provided with mounting pads 30 for attachment to a frame 28 on the recipient vehicle. Advantageously, these mounting pads 30 have an essentially square shape and comprise a first flange-like portion 27 bored centrally to let a screw fastener 29 therethrough, and a second, supporting portion 31 having either the means 10 or counter-means 11 formed integrally thereon for securing the pads 30 laterally on the case 1, as the case may be.

It may be appreciated from the foregoing description that the carrier case 1 of this invention is constructed to allow a number of such cases to be assembled modularly together which all have the same interfitting feature.

With a carrier case according to the invention, fuse and/or relay carrier box sets can be provided, therefore, having a modularly composed structure.

The inventive carrier case may be altered and modified, moreover, by a skilled person in the art within the scope of the invention as defined in the appended claims. Thus, it will be recognized that the principles which underlie this invention would also apply to a carrier case designed to accommodate large-size fuses, such as the so-called "maxi-fuses", or quick-coupling connectors.

## Claims

1. A fuse-carrier case (1) of a kind intended for installation on vehicles in order to accommodate fuses, relays, connectors, and the like electrical devices (4,5), in correspondingly arranged seats (3) therein, and comprising a plurality of carrier cases each reserved for one type of said electrical devices (4,5) and peripherally arranged interfit means (10) and counter-means (11) adapted to releasably hold together in a modular fashion said plurality of carrier cases,
characterized in that said means (10) and counter-means (11) are formed integrally with side walls (8) of the carrier case, and
in that it includes a closure cover (15) snap fitted thereon in a releasable fashion, said cover (15) having inward projections (16) arranged at the locations of said electrical devices (4,5) and abutting thereon with the cover secured in its closed position.

2. A carrier case according to Claim 1, characterized in that said projections (16) are lengthwise ribs on the cover (15).

3. A carrier case according to Claim 1, characterized in that it accommodates on its interior electric connection terminals (36) for said devices (4,5) and includes additional locking means (20) for securing said connectors (18) in the connected position.

4. A carrier case according to Claim 3, characterized in that said locking means (20) include a bar (40) slid in a guided fashion through a side opening (39) of the case and interfering in a substantially latch-like fashion with said connectors (36).

5. A carrier case according to Claim 6, characterized in that said bar (40) has an end formed with a locking pawl (41) adapted to become engaged by snap action on passing said opening (39).

## Patentansprüche

1. Sicherungskasten (1) der Art, wie sie zur Installation an Fahrzeugen vorgesehen ist, um Sicherungen, Relais, Steckverbinder und dergleichen elektrische Bauelemente (4, 5) in entsprechend angeordneten Fassungen (3) aufzunehmen, umfassend mehrere Trägergehäuse, die jeweils für einen Typ der elektrischen Bauelemente (4, 5) reserviert und am Umfang mit Kopplungs-Mitteln (10) und dazugehörigen Gegenstücken (11) ausgestattet sind, die dazu dienen, die Trägergehäuse in modularer Weise lösbar zusammenzuhalten,
**dadurch gekennzeichnet**, daß die Mittel und Gegenstücke (11) einstückig mit Seitenwänden (8) des Trägergehäuses ausgebildet sind, und daß er einen Verschlußdeckel (15) aufweist, der lösbar auf ihn aufgeschnappt ist, wobei der Deckel (15) Innenvorsprünge (16) an den Stellen der elektrischen Bauelemente (4, 5) aufweist, die an diesen zur Anlage gelangen, wenn der Deckel sich in seiner Schließstellung befindet.

2. Sicherungskasten nach Anspruch 1, **dadurch gekennzeichnet**, daß die Vorsprünge (16) durch Längsrippen an dem Deckel (15) gebildet sind.

3. Sicherungskasten nach Anspruch 1, **dadurch gekennzeichnet**, daß er in seinem Inneren elektrische Verbinderanschlüsse (36) für die Bauelemente (4, 5) aufnimmt und zusätzliche Verriegelungsmittel (20) enthält, um die Verbinder (18) in der Verbindungslage zu sichern.

4. Sicherungskasten nach Ansprpuch 3, **dadurch gekennzeichnet**, daß die Verriegelungseinrichtung (20) einen Stab (40) aufweist, der in geführter Weise durch eine Gleitöffnung (39) des Gehäuses geschoben wird und in im wesentlichen verrasteter Weise mit den Verbindern (36) in Eingriff tritt.

5. Sicherungskasten nach Anspruch 6, **dadurch gekennzeichnet**, daß der Stab (40) an einem Ende mit einer Rastklaue (41) versehen ist, die beim Vorbeilaufen an der Öffnung (39) einschnappend verrastet.

## Revendications

1. Boîtier porte-fusibles (1) d'un type destiné à être installé sur des véhicules afin de loger des fusibles, des relais, des connecteurs, et des dispositifs électriques similaires (4, 5), dans des logements agencés en correspondance (3) à l'intérieur, et comprenant une pluralité de boîtiers supports chacun réservé à un type desdits dispositifs électriques (4, 5) et des moyens (10) d'interajustage agencés de manière périphérique et des contre-moyens (11) adaptés pour retenir ensemble de manière amovible ladite pluralité de boîtiers supports d'une façon modulaire,
caractérisé en ce que lesdits moyens (10) et contre-moyens (11) sont formés d'un seul tenant avec les parois latérales (8) du boîtier support, et
en ce qu'ils comprennent un cliquet de couvercle de fermeture (15) ajustés sur ceux-ci de manière amovible, ledit couvercle (15) ayant des saillies intérieures (16) agencées aux emplacements des dispositifs électriques (4, 5) et venant en butée dessus avec le couvercle fixé dans sa position fermée.

2. Boîtier support selon la revendication 1, caractérisé en ce que lesdites saillies (16) sont des nervures longitudinales s'étendant sur le couvercle (15).

3. Boîtier support selon la revendication 1, caractérisé en ce qu'il contient à l'intérieur des bornes de connexion électriques (36) pour lesdits dispositifs (4, 5) et comprend des moyens de verrouillage supplémentaires (20) pour fixer lesdits connecteurs (18) dans la position de connexion.

4. Boîtier support selon la revendication 3, caractérisé en ce que lesdits moyens de verrouillage (20) comprennent un pêne (40) glissé de manière guidée à travers une ouverture latérale (39) du boîtier et interférant de manière sensiblement similaire à un verrou avec lesdits connecteurs (36).

5. Boîtier support selon la revendication 6, caractérisé en ce que ledit pêne (40) a une extrémité formée avec un cliquet de verrouillage (41) adapté pour se mettre en prise par une action d'encliquetage en passant dans ladite ouverture (39).
